# EUROPÄISCHE PATENTANMELDUNG

(11) **EP 1 345 485 A2**
(43) Veröffentlichungstag der Anmeldung: **17.09.2003**
(21) Anmeldenummer: 03005328.4
(22) Anmeldetag: 11.03.2003
(51) Int. Cl.: H05K 9/00

(54) **Gerätegehäuse mit einem elektromagnetisch abgeschirmten Raumbereich**

(30) Priorität: 11.03.2002 DE 10210578
(71) Anmelder: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Heinze, Ekkehard, Dipl.-Phys. Dr.

(57) **Zusammenfassung**

Gerätegehäuse eines elektronischen Gerätes mit einem elektromagnetisch abgeschirmten Raumbereich, der mindestens eine Abschirmwand aufweist, die aus einer Mehrzahl von im wesentlichen übereinander auf einen Träger dispensierten und insbesondere stoffeinheitlich miteinander verbundenen Strängen aus einem Elastomeren oder Weichkunststoff aufgebaut oder aus einem einzelnen hohen Elastomer- oder Weichkunststoffstrang mit einer Höhe, die mindestens das Doppelte seiner Breite beträgt, gebildet ist, wobei das Elastomere bzw. der Weichkunststoff leitfähig gefüllt und/oder die Abschirmwand insgesamt leitfähig beschichtet ist.

## Beschreibung

Die Erfindung betrifft ein Gerätegehäuse für ein elektronisches Gerät mit mindestens einem elektromagnetisch abgeschirmten Raumbereich zur Aufnahme von elektromagnetische Störstrahlung aussendenden oder gegen solche empfindlichen Bauelementen.

Derartige Gerätegehäuse werden heute zum weit überwiegenden Teil aus Kunststoff spritzgegossen und anschließend - vorrangig mittels galvanischer Verfahren - mindestens abschnittsweise metallisiert, um ihnen die zur Erzielung der benötigten EMI-Abschirmwirkung erforderliche Oberflächen-Leitfähigkeit zu verleihen. An den Stoßkanten der mehrteiligen Gehäuseaufbauten sind EMI-abschirmend wirkende Dichtungen (auch bezeichnet als Abschirmdichtungen) vorgesehen, um das Gehäuse lückenlos abschirmend zu gestalten. Derartige Abschirmdichtungen können separat gefertigt und in die entsprechenden Kantenbereiche eingelegt oder dort aufgeklebt werden, oder sie werden unter Einsatz eines geeigneten Formwerkzeuges an Ort und Stelle gebildet (FIPG-Verfahren). Schließlich ist es seit einiger Zeit bekannt, derartige Abschirmdichtungen sowohl zwischen verschiedenen Gehäuseteilen als auch zwischen Gehäuseteilen und Platinen an Ort und Stelle mittels einer computergesteuert geführten Nadel oder Düse zu erzeugen und unter Umgebungsbedingungen erhärten zu lassen, bevor das Gehäuse geschlossen wird oder die Teile miteinander verbunden werden.

Als Stand der Technik zum letztgenannten Typ von Abschirmdichtungen werden die EP 0 629 114 B1, die EP 0 654 962 B1, die WO 98/06246, die WO 98/08365 sowie die WO 01/99483 genannt.

Hierbei ist es auch - etwa aus der EP 0 629 114 B1 - bekannt, Abschirmdichtungen durch mehrfachen Auftrag von Dichtmaterial auf ein und denselben Gehäuseabschnitt mittels der erwähnten Dispensernadeln bzw. -düsen mehrschichtig aufzubauen und dabei auch relativ komplizierte Dichtungsprofile herzustellen, die speziellen konstruktiven Anforderungen Rechnung tragen.

Der Erfindung liegt die Aufgabe zugrunde, ein weiter verbessertes Gerätegehäuse der in Rede stehenden Art anzugeben, welches einfach und kostengünstig herstellbar und flexibel an geänderte Konstruktionsvorgaben anpassbar ist.

Diese Aufgabe wird durch ein Gerätegehäuse mit den Merkmalen des Anspruchs 1 gelöst.

Zweckmäßige Fortbildungen des Erfindungsgedankens sind Gegenstand der abhängigen Ansprüche.

Die Erfindung schließt den wesentlichen Gedanken ein, mittels des an sich bekannten Dispens-Verfahrens eine regelrechte "Abschirmwand", also eine mit EMI-Abschirmwirkung ausgestattete Gehäusewandung, zu formen, statt sie mit einem Formwerkzeug für einen Primär-Formvorgang (Spritzgießen oder Druckgießen) oder eine Verformung (Tiefziehen o.ä.) festlegen zu müssen. Weiterhin schließt die Erfindung den Gedanken ein, das zur Bildung dieser Abschirmwand einzusetzende Material derart auszuwählen, dass sich die Abschirmwand entweder in einem Arbeitsschritt formstabil mit einer Höhe erzeugen lässt, die mindestens das Doppelte ihrer Breite beträgt, oder dass sie sich aus mehreren, im wesentlichen übereinander gelegten Materialsträngen weitgehend formstabil aufbauen lässt. Schließlich gehört zur Erfindung der Gedanke einer hierauf abgestimmten Durchführung des Dispensvorganges, sowohl hinsichtlich des Austrag-Querschnittes als auch der Auftraggeschwindigkeit des Ausgangsmaterials und weiterer Parameter, wie des zeitlichen Abstandes mehrerer Auftragschritte, des Nadelabstandes zur jeweiligen Oberfläche, der Verfahrenstemperatur etc.

Die Erfindung beschreibt eine preiswerte Möglichkeit, eine Teilabschirmung innerhalb eines Gehäuses oder eine Abschirmung für ein gesamtes Gehäuse herzustellen. Die Lösung reduziert die Herstellzeiten und somit die Kosten gegenüber derzeit am Markt befindlichen "Molding EMI-Gaskets".

Im Gegensatz zu bisherigen mit leitfähigem Material "gemoldeten" Dichtungen, die auf Trägermaterialien, wie z.B. einfache Bleche oder metallisierte Kunststoffträger, aufgebracht werden, ist die Erfindung auf kein Werkzeug zur Bestimmung der Dichtungsgeometrie angewiesen.

Hierdurch kann z.B. die Außenwand einer Abschirmkappe gebildet werden, und auch interne Verrippungen sind hiermit einfach möglich.

Durch das aufdispensierte Material entstehen die Wandflächen zur Abgrenzung eines Raumes, der die abzuschirmende(n) elektronische(n) Baugruppe (ggf. mit Leiterplatte) aufnimmt.

In Abstimmung auf die Geometrie des Trägers (Blechs, Metall-Gussteiles oder metallisierten Kunststoffteiles) lassen sich auch unterschiedlich hohe Dichtungsverläufe herstellen, so dass die "Abschirmwände" des Abschirmelementes an spezielle örtliche Gegebenheiten angepasst werden können.

Eine spezielle Ausführung der Erfindung ist die Dispensierung der Abschirmwände aus nicht elektrisch leitendem Elastomer, thermoplastischem bzw. duroplastischen Kunststoffen/Elastomeren, die anschließend mittels Galvanik, Sputtern, Vakuumbedampfen oder Bespritzen mit elektrisch leitfähigen Lacken eine elektrisch leitfähige Oberfläche erhalten.

Der Träger kann allgemein aus einer Folie (größer 1 µ) isolierend oder auch metallisiert oder auch insgesamt aus Metall bestehen und bis zu starren Trägern, wie Gehäusen (Kunststoff/Metall) mit mechanischer Trägerfunktion, gehen. Auch hier sind erfindungsgemäße Abschirmwände möglich. Auch eine Kombination mit herkömmlich geformten, angespritzten, gespritzten oder mechanisch geformten Wänden ist möglich.

Die Befestigung der entsprechenden Gehäuseteile kann in konstruktiv zweckmäßiger Form direkt oder indirekt durch Anpressen, Anschrauben, Kleben oder Schnappsysteme etc. erfolgen.

In einer ersten bevorzugten Ausführung der Erfindung ist der Raumbereich im wesentlich rundum von einer Abschirmwand aus übereinanderliegenden Elastomer- oder Weichkunststoffsträngen bzw. dem hohen Elastomer- oder Weichkunststoffstrang umgeben. Die Festlegung des abzuschirmenden Bereiches kann somit vollständig softwaregesteuert durch geeignete Führung der Dispensnadel bzw. Dispensnadeln erfolgen. Alternativ ist selbstverständlich die Kombination mit per Spritzguss oder einem anderen Urform- oder Verformungsverfahren unter Einsatz eines entsprechenden Formwerkzeuges gebildeten abschirmenden Wandbereichen möglich.

In einer weiteren sinnvollen Ausführung der Erfindung liegt mindestens eine Abschirmwand aus Elastomer- oder Weichkunststoffsträngen bzw. dem hohen Elastomer- oder Weichkunststoffstrang, insbesondere der gesamte abgeschirmte Raumbereich, im Inneren des Gerätes. In Kombination hiermit oder auch alternativ hierzu bildet mindestens eine Abschirmwand aus Elastomeroder Weichkunststoffsträngen bzw. dem hohem Elastomer- oder Weichkunststoffstrang einen Außenwandabschnitt des Gerätes. Insgesamt ist es mit der Erfindung in vorteilhafter Weise möglich, mehrere von aneinanderstoßenden Abschirmwänden umgebene abgeschirmte Raumbereiche zu bilden, wodurch den konstruktiven Erfordernissen komplexer, multifunktioneller elektronischer Geräte (z.B. kombinierter Mobiltelefone/PDA) in flexibler Weise Rechnung getragen werden kann.

In einer für miniaturisierte elektronische Geräte moderner Bauart geeigneten Ausführung hat die oder mindestens eine Abschirmwand mindestens drei, vorzugsweise fünf oder mehr, Stränge und ist mindestens 2 mm hoch. Es versteht sich, dass die Abschirmwand-Höhe in Anpassung an die in den Abschirmbereichen unterzubringenden elektronischen Komponenten auch größer sein kann bzw. - wie in den Ausführungsbeispielen noch deutlicher werden wird - Wandbereiche unterschiedlicher Höhe und verschiedenartigen Aufbaus in einem Gerätegehäuse miteinander kombiniert sein können.

Des weiteren wird der Träger und/oder eine Abdeckung des abgeschirmten Raumbereiches aus Metall, insbesondere dünnem, biegeelastischem Metallblech, besteht, welches so gehalten ist, dass ein im wesentlichen durchgehender Linienkontakt zwischen der Abschirmwand und der Abdeckung hergestellt. Alternativ hierzu oder auch in Kombination hiermit besteht der oder einer der Träger und/oder eine Abdeckung des abgeschirmten Raumbereiches aus einer metallisierten Kunststoffplatte oder -folie, welche so gehalten ist, dass ein im wesentlichen durchgehender Linienkontakt zwischen der Abschirmwand und der Abdeckung hergestellt wird. Mit diesen Varianten lassen sich Gerätegehäuse für die verschiedensten modernen elektronischen Geräte bereitstellen, die sowohl den mechanischen als elektromagnetischen Anforderungen des jeweiligen Gerätes praktisch beliebig anpassbar sind.

In einer weiteren sinnvollen Ausführung ist der Träger oder eine Abdeckung des abgeschirmten Raumbereiches als Leiterplatte mit elektronischen Bauelementen ausgebildet. Diese Variante trägt dem Umstand Rechnung, dass bei miniaturisierten elektronischen Geräten moderner Bauart häufig Leiterplatten bzw. Bauelementträger zugleich Funktionen des mechanischen Gehäuseaufbaus haben.

Die zur EMI-Abschirmung benötigte elektrische Leitfähigkeit wird in einer ersten Variante dadurch erzielt, dass das Elastomere bzw. der Weichkunststoff mit Metall- und/oder Kohlenstoffteilchen gefüllt ist. Eine andere Variante sieht vor, dass die Abschirmwand mindestens einseitig mit einer leitfähigen Dünnschicht, insbesondere Aufdampf-, Sprüh- oder Sputterschicht, bedeckt ist, welche sich bis zu dem Träger erstreckt, derart, dass Träger und Abschirmwand zusammenhängend abschirmend wirken. Beide Varianten sind auch - jedenfalls für spezielle Anwendungen mit besonders hohen Ansprüchen hinsichtlich der EMI-Abschirmwirkung - kombinierbar.

In einer weiteren Ausführungsform der Erfindung ist vorgesehen, dass mindestens eine Abschirmwand aus einem einzelnen hohen Elastomer- oder Weichkunststoffstrang und mindestens eine weitere Abschirmwand aus einer Mehrzahl übereinanderliegender Elastomerstränge gebildet ist. Hiermit lassen sich mit ein und demselben Verfahren und unter Einsatz eines einzigen Materials Abschirmwände bzw. abschirmende Dichtungsbereiche mit deutlich unterschiedlichen Höhen bilden, wodurch mit einfachen Mitteln und auf kostengünstige Weise eine hochgradige Flexibilität in der Gehäusekonstruktion erreichbar ist.

Geräte der in Rede stehenden Art sind insbesondere Mobilfunk-Endgeräte oder andere Telekommunikations-Endgeräte oder Komponenten von Mobilfunknetzen (insbesondere Basisstationen), die eine Quelle von EMI bilden oder gegen solche empfindlich sind, oder auch EMI-störungsempfindliche Datenkommunikations- oder Datenverarbeitungsgeräte und Teile von solchen. Weiterhin kann es sich um Geräte aus den Gebieten der Sensorik, Betriebsmesstechnik und Prozesssteuertechnik, Funknavigationsgeräte o.ä. handeln.

Vorteile und Zweckmäßigkeiten der Erfindung ergeben sich im übrigen aus der nachfolgenden, lediglich skizzenhaften Beschreibung bevorzugter Ausführungsbeispiele und -aspekte. Von den Figuren zeigen:
- Fig. 1: eine schematische Darstellung eines Gehäuseteils gemäß einer Ausführungsform der Erfindung in Seitenansicht,
- Fig. 2A: eine (ebenfalls schematische) perspektivische Darstellung einer weiteren Ausführungsform,
- Fig. 2B: Querschnittsdarstellungen von zweckmäßigen Abschirmwand- bzw. Abschirmdichtungs-Profilen,
- Fig. 3 und 4: schematische Darstellungen weiterer Ausführungsformen der Erfindung in Art von Seitenansichten bzw. Querschnittsdarstellungen,
- Fig. 5: eine schematische Querschnittsdarstellung eines Gerätegehäuses gemäß einer ersten Ausführungsform der Erfindung und
- Fig. 6: eine schematische Querschnittsdarstellung eines Gerätegehäuses gemäß einer zweiten Ausführungsform der Erfindung.

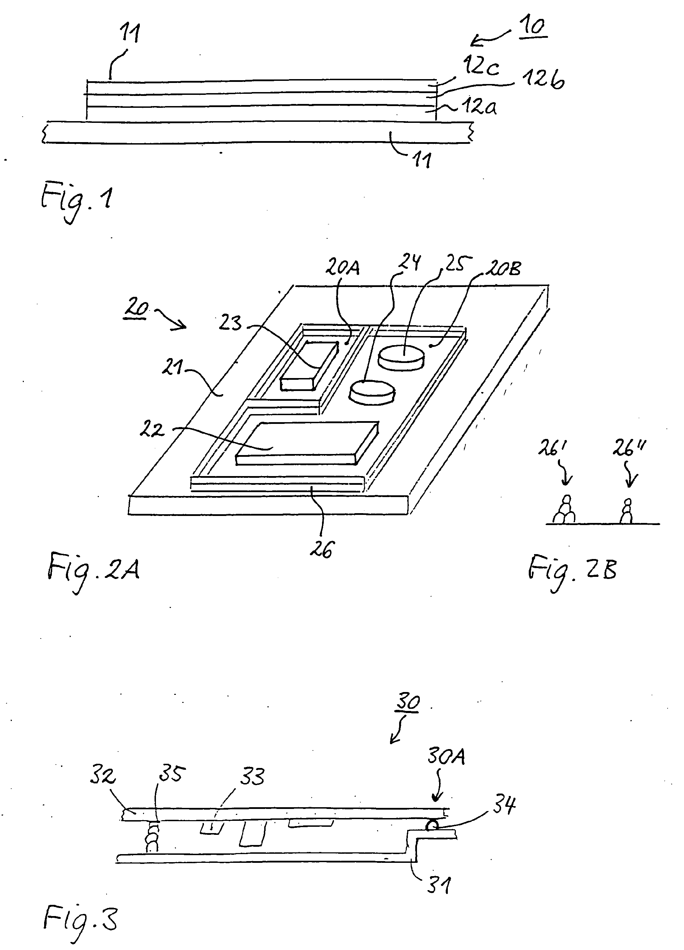

Fig. 1 zeigt schematisch den Aufbau eines Gehäuseteiles 10 eines Abschirmgehäuses für ein EMI-sensibles elektronisches Gerät, bei dem auf einen planen Träger (z.B. ein unverformtes Metallblech oder eine metallisierte Kunststoffplatte) 11 ein Drei-Strang-Profil 12 aus einem leitfähig gefüllten Elastomeren oder Weichkunststoff mittels des an sich bekannten Dispens-Verfahrens aufgebracht ist. Das Profil 12 ist durch dreimaliges Führen einer Dispensiernadel bzw. -düse über den Träger 11 mit übereinstimmenden XY-Koordinaten und unter Anhebung um einen vorbestimmten Höhenbetrag gebildet, der in etwa der Höhe des im vorangehenden Schritt aufgebrachten Stranges entspricht. Es umfasst also drei im wesentlichen gleich hohe Materialstränge 12a, 12b, 12c. Als Alternative zu einer leitfähigen Füllung kann das Drei-Strang-Profil auch aus einem ungefüllten Elastomeren oder Weichkunststoff gebildet sein und anschließend mit einer leitfähigen Beschichtung (Dünnschicht) versehen werden.

Fig. 2A zeigt in schematischer perspektivischer Darstellung eine Komponente 20 eines elektronischen Gerätes, in der auf einem Träger 21 (hier insbesondere einer Leiterplatte bzw. Platine) mehrere elektronische Bauteile 22 bis 25 in zwei elektromagnetisch voneinander getrennten und jeweils abgeschirmten Raumbereichen 20A und 20B angeordnet sind.

Auf Seiten des Trägers 21 wird die Abschirmung durch eine (nicht dargestellte) metallische Beschichtung desselben sichergestellt. Die Umfassungskanten der abgeschirmten Raumbereiche 20A, 20B sind durch eine zweilagig aufdispensierte Abschirmdichtung 26 mit dem in der Figur dargestellten Verlauf gebildet. Komplettiert wird die Abschirmung durch ein auf die Abschirmdichtung 26 aufgelegtes (in der Figur nicht dargestelltes) Gehäuseteil mit Abschirmwirkung, z.B. aus Metall oder mit metallisierter Oberfläche.

In Fig. 2B sind schematisch zwei Profilformen von modifizierten, drei- bzw. vierteiligen Abschirmdichtungen 26' bzw. 26'' zur Ersetzung der Abschirmdichtung 26 nach Fig. 2A bei größerem Höhenbedarf dargestellt. Hierbei ist das dreiteilige Profil auf der rechten Seite von Fig. 2B etwas leichter zu erzeugen, während das vierteilige Profil 26' auf der linken Seite der Figur, mit zwei nebeneinander angeordneten Basis-Strängen, zwar etwas höheren Aufwand erfordert, aber deutlich höheren Stabilitätsanforderungen genügt.

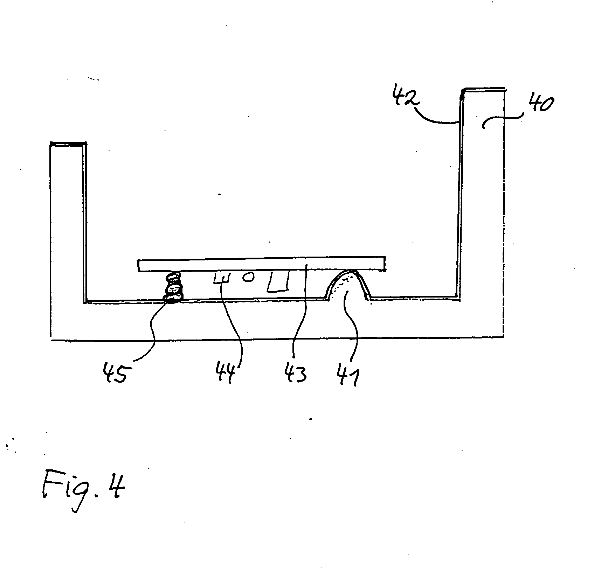

Fig. 3 zeigt (in ähnlich schematischer Darstellung wie die Figuren 1 bis 2B) in Art einer Querschnittsdarstellung einen Ausschnitt eines Gerätegehäuses 30 mit einem insgesamt wannenartigen Unterteil 31 und einem im wesentlichen ebenen Deckel 32, welches elektronische Bauteile 33 enthält. In einem Außenkantenbereich 30A ist eine aufdispensierte Außenkantendichtung 34 herkömmlicher Art vorgesehen, während im Inneren des Gerätegehäuses 30 aus vier Strängen des auch für die Außenkantendichtung 34 verwendeten Elastomeren oder Weichkunststoffes eine innenliegende Abschirmwand 35 erzeugt ist. Zweckmäßigerweise kann die Außenkantendichtung 34 zusammenhängend mit einem der die Abschirmwand 35 bildenden Teilstränge hergestellt sein, um einen zuverlässig lückenlosen EMI-Kantenschutz des Gehäusebereiches, in dem die elektronischen Komponenten 33 angeordnet sind, zu bilden.

Fig. 4 zeigt als weitere Ausführungsform ein Gehäuseunterteil 40 eines elektronischen Gerätes mit U-förmigem Querschnitt aus einem relativ weichen Kunststoffmaterial, an das im Bodenbereich eine Dichtwulst 41 materialeinheitlich angeformt ist. Die Gehäuseinnenseite ist, einschließlich der Kantenbereiche und der Dichtwulst 41, mit einer metallischen Beschichtung 42 versehen. Auf der Dichtwulst 41 liegt, nahe einer ihrer Seitenkanten, eine Platine 43 mit elektronischen Bauteilen auf. Nahe dem gegenüberliegenden Kantenbereich wird die Platine 43 auf dem Boden des Gehäuseunterteils 40 durch ein Drei-Strang-Profil 45 der bereits in Fig. 1 in Seitenansicht dargestellten Art gelagert. Das Profil 45 ist durch leitfähige Füllung als Abschirmprofil ausgeführt und bildet zusammen mit der metallischen Beschichtung 42 des Gehäuseunterteils und einer ähnlichen (nicht dargestellten) Beschichtung der Platine 43 einen EMI-abgeschirmten Raumbereich für die Bauteile 44.

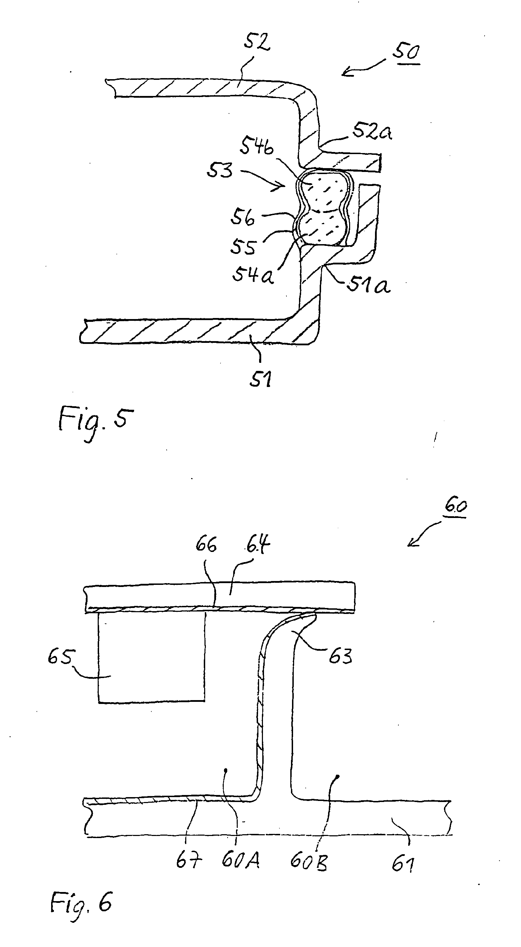

Fig. 5 zeigt einen Ausschnitt eines Gerätegehäuses 50 aus Metall, etwa aus tiefgezogenem Al-Blech, das eine untere Gehäuseschale 51 und eine obere Gehäuseschale 52 aufweist, die durch in der Figur nicht dargestellte Befestigungsmittel (beispielsweise Schrauben oder eine Rastverbindung) miteinander verbunden sind. In einem Kantenbereich des Gehäuses 50, in dem die untere und obere Gehäuseschale 51, 52 einen Abkantungsbereich 51a bzw. 52a aufweisen, ist zwischen beide eine abschirmende Gehäuseaußendichtung 53 eingefügt.

Die Gehäuseaußendichtung 53 ist aus zwei übereinander auf den Abkantungsbereich 51a der unteren Gehäuseschale 51 aufdispensierten Elastomersträngen 54a, 54b aufgebaut. Von diesen haftet der untere Elastomerstrang 54a fest auf der Oberfläche der unteren Gehäuseschale 51, und der obere Elastomerstrang 54b hat sich infolge seines Aufbringens unmittelbar nach der Bildung des unteren Elastomerstranges 54a materialeinheitlich mit diesem verbunden. Auf das hiermit gebildete Basis-Dichtprofil 54a/54b ist zunächst eine Kupfer-Dünnschicht als hochgradig leitfähige Basisschicht und hierauf eine Deckschicht 56 aus einer Zinnlegierung mit niedrigem Bleigehalt, jeweils in einem Hochvakuum-Beschichtungsverfahren, aufgebracht. Die Schichtdicken der Basisschicht 55 und der Deckschicht 56 sind zur Erzielung der geforderten Verformbarkeit der Gehäuseaußendichtung 53 einerseits und ihrer Abschirmwirkung andererseits festgelegt, wobei in Abhängigkeit vom Einsatzzweck des Gehäuses 50 auch die Beständigkeit gegenüber Umwelteinflüssen (Feuchtigkeit, Salzwasser o.ä.) zu beachten ist.

Fig. 6 zeigt schematisch in einer Querschnittsdarstellung einen Gehäuseabschnitt eines mittels Kunststoff-Spritzguss aus einem thermoplastischen Polymeren hergestellten Gehäuses 60, von dem nur ein unteres Gehäuseteil 61 mit einer senkrecht aufstehenden Trennwand 62 dargestellt ist. Die Trennwand 62 trennt einen gegen EMI abzuschirmenden ersten Gehäusebereich 60A mechanisch und elektromagnetisch dicht von einem zweiten Gehäusebereich 60B ab. Auf der Oberkante der Trennwand 62, die mit verjüngtem Querschnitt in Form einer biegeverformbaren Dichtlippe 63 ausgeführt ist, liegt eine Leiterplatte 64 mit elektronischen Komponenten auf, von denen symbolisch ein EMI-empfindliches Bauteil 65 dargestellt ist.

Nach oben ist der erste Gehäusebereich 60A elektromagnetisch durch eine leitende Oberflächenbeschichtung 66 der Leiterplatte 64 im wesentlichen dicht abgeschlossen. Nach unten und zur Seite hin wird die elektromagnetische Abschirmung durch eine auf den linken Abschnitt des unteren Gehäuseteils 61 und die sich hieran anschließende (linke) Oberfläche der Trennwand 62 ganzflächig aufgebrachte Zinnlegierungsschicht 67 gewährleistet.

Die Ausführung der Erfindung ist nicht auf die oben beschriebenen Beispiele und hervorgehobenen Aspekte der Erfindung beschränkt, sondern ebenso in einer Vielzahl von Abwandlungen und insbesondere Kombinationen der beschriebenen Aspekte möglich, die im Rahmen fachgemäßen Handelns liegen.

### Bezugszeichenliste

- 10: Gehäuseteil
- 11: Träger
- 12; 45: Drei-Strang-Profil
- 12a, 12b, 12c: Materialstrang
- 20: Komponente
- 20A, 20B: abgeschirmter Raumbereich
- 21: Träger
- 22, 23, 24, 25: Bauteil
- 26; 26', 26'': Abschirmdichtung
- 30: Gerätegehäuse
- 31: Unterteil
- 32: Deckel
- 33: Bauteil
- 34: Außenkantendichtung
- 35: Abschirmwand
- 40: Gehäuseunterteil
- 41: Dichtwulst
- 42: metallische Beschichtung
- 43: Platine
- 44: Bauteil
- 50; 60: Gehäuse
- 51; 61: untere Gehäuseschale
- 51a: Abkantung
- 52: obere Gehäuseschale
- 52a: Abkantung
- 53: Gehäuseaußendichtung (Abschirmdichtung)
- 54a, 54b: Elastomerstrang
- 54a/54b: Basis-Dichtprofil
- 55: Kupfer-Dünnschicht (Basisschicht)
- 56; 67: Zinnlegierungsschicht (Deckschicht)
- 60A, 60B: Gehäusebereich
- 62: Trennwand
- 63: Dichtlippe
- 64: Leiterplatte
- 65: Bauteil
- 66: Oberflächenbeschichtung

## Patentansprüche

1. Gerätegehäuse eines elektronischen Gerätes mit einem elektromagnetisch abgeschirmten Raumbereich, der mindestens eine Abschirmwand aufweist, die aus einer Mehrzahl von im wesentlichen übereinander auf einen Träger dispensierten und insbesondere stoffeinheitlich miteinander verbundenen Strängen aus einem Elastomeren oder Weichkunststoff aufgebaut oder aus einem einzelnen hohen Elastomeroder Weichkunststoffstrang mit einer Höhe, die mindestens das Doppelte seiner Breite beträgt, gebildet ist, wobei das Elastomere bzw. der Weichkunststoff leitfähig gefüllt und/oder die Abschirmwand insgesamt leitfähig beschichtet ist.

2. Gerätegehäuse nach Anspruch 1,
**dadurch gekennzeichnet, dass**
der Raumbereich im wesentlich rundum von einer Abschirmwand aus übereinanderliegenden Elastomer- oder Weichkunststoffsträngen bzw. dem hohen Elastomer- oder Weichkunststoffstrang umgeben ist.

3. Gerätegehäuse nach Anspruch 1 oder 2,
**dadurch gekennzeichnet, dass** mindestens eine Abschirmwand aus Elastomer- oder Weichkunststoffsträngen bzw. dem hohem Elastomer- oder Weichkunststoffstrang, insbesondere der gesamte abgeschirmte Raumbereich, im Inneren des Gerätes liegt.

4. Gerätegehäuse nach einem der vorangehenden Ansprüche,
**dadurch gekennzeichnet, dass** mindestens eine Abschirmwand aus Elastomer- oder Weichkunststoffsträngen bzw. dem hohem Elastomer- oder Weichkunststoffstrang einen Außenwandabschnitt des Gerätes bildet.

5. Gerätegehäuse nach einem der vorangehenden Ansprüche,
**dadurch gekennzeichnet, dass**
die oder mindestens eine Abschirmwand mindestens drei, vorzugsweise fünf oder mehr, Stränge aufweist und mindestens 2 mm hoch ist.

6. Gerätegehäuse nach einem der vorangehenden Ansprüche,
**gekennzeichnet durch**
mehrere von aneinanderstoßenden Abschirmwänden umgebene abgeschirmte Raumbereiche.

7. Gerätegehäuse nach einem der vorangehenden Ansprüche,
**dadurch gekennzeichnet, dass**
der Träger und/oder eine Abdeckung des abgeschirmten Raumbereiches aus Metall, insbesondere dünnem, biegeelastischem Metallblech, besteht, welches so gehalten ist, dass ein im wesentlichen durchgehender Linienkontakt zwischen der Abschirmwand und der Abdeckung hergestellt wird.

8. Gerätegehäuse nach einem der vorangehenden Ansprüche,
**dadurch gekennzeichnet, dass**
der Träger und/oder eine Abdeckung des abgeschirmten Raumbereiches aus einer metallisierten Kunststoffplatte oder -folie besteht, welche so gehalten ist, dass ein im wesentlichen durchgehender Linienkontakt zwischen der Abschirmwand und der Abdeckung hergestellt wird.

9. Gerätegehäuse nach einem der vorangehenden Ansprüche,
**dadurch gekennzeichnet, dass**
der Träger oder eine Abdeckung des abgeschirmten Raumbereiches als Leiterplatte mit elektronischen Bauelementen ausgebildet ist.

10. Gerätegehäuse nach einem der vorangehenden Ansprüche,
**dadurch gekennzeichnet, dass**
das Elastomere bzw. der Weichkunststoff mit Metallund/oder Kohlenstoffteilchen gefüllt ist.

11. Gerätegehäuse nach einem der vorangehenden Ansprüche,
**dadurch gekennzeichnet, dass**
die Abschirmwand mindestens einseitig mit einer leitfähigen Dünnschicht, insbesondere Aufdampf-, Sprüh- oder Sputterschicht, bedeckt ist, welche sich bis zu dem Träger erstreckt, derart, dass Träger und Abschirmwand zusammenhängend abschirmend wirken.

12. Gerätegehäuse nach einem der vorangehenden Ansprüche,
**dadurch gekennzeichnet, dass**
mindestens eine Abschirmwand aus einem einzelnen hohen Elastomer- oder Weichkunststoffstrang und mindestens eine weitere Abschirmwand aus einer Mehrzahl übereinanderliegender Elastomerstränge gebildet ist.

13. Gerät mit einem Gerätegehäuse nach einem der vorangehenden Ansprüche,
**gekennzeichnet durch**
die Ausbildung als Tele- oder Datenkommunikationsgerät.
